**Europäisches Patentamt**

**European Patent Office**

**Office européen des brevets**

(19)

(11) Publication number: **0 106 738**

**A2**

(12) # EUROPEAN PATENT APPLICATION

(21) Application number: **83401826.9**

(22) Date of filing: **20.09.83**

(51) Int. Cl.³: **H 03 G 3/20**

(30) Priority: **22.09.82 US 421216**

(43) Date of publication of application:
**25.04.84 Bulletin 84/17**

(84) Designated Contracting States:
**DE FR GB IT NL**

(71) Applicant: **FAIRCHILD WESTON SYSTEMS INC.**
**Fruitville & Packinghouse Roads**
**Sarasota Florida 33578(US)**

(72) Inventor: **Bobrek, Pavlo**
**4355-D Colonial Circle**
**Bradenton Florida 33508(US)**

(74) Representative: **Chareyron, Lucien**
**Schlumberger Limited Service Brevets 42, rue**
**Saint-Dominique**
**F-75340 Paris Cedex 07(FR)**

(54) **AGC method and apparatus.**

(57) An improved AGC circuit utilizes a two-stage amplifier/attenuator wherein each stage of the circuit comprises at least one JFET having its gate biased by a buffered feedback voltage derived from both the signal and control voltages. The dynamic range of each stage can be increased by paralleling additional JFETs in each stage. The buffers in the feedback loop are broadband to allow control down to DC, provide isolation between each stage and the signal output and help to minimize the amount of signal offset introduced into the signal by the control voltage.

FIG. 1

AGC METHOD AND APPARATUS

## Background of the Invention

### Field of the Invention

The invention relates to the field of automatic gain control (AGC) circuits, and more particularly to a AGC circuit having buffered feedback of the output signal.

### Description of the Prior Art

AGC circuits are commonly used in radio and other telecommunications receivers. An AGC circuit is basically an amplifier for receiving an input signal with the gain of the amplifier being controlled in inverse proportion to the strength or amplitude of the signal. The AGC control signal is generally derived from a diode rectifier connected to the input signal. The output of the diode is applied to a resistance, with the value of the voltage across the resistance being proportional to the average strength of the input signal. This control signal is then used to control the gain of one or more cascaded amplifier stages.

One popular type of amplifier uses a junction field effect transistor (JFET). In a JFET the drain is biased positive with respect to the source and is characterized by there being maximum current when no potential is applied to the gate. As the potential on the gate is made increasingly negative the depletion region in the JFET is narrowed thus causing the source-to-drain resistance to rise and the current flow to fall. At a gate voltage $V_p$ (the "pinch-off" voltage), whose value depends on the particular device being used, current flow between the source and drain will be completely cut off. Since the gate terminal is always reverse-biased the JFET will have a very high input resistance.

One problem associated with using JFETs in an AGC circuit is that for a given control voltage applied to the gate the resistance from source to drain varies with the applied signal voltage. Thus the operation of the JFET will be nonlinear with respect to changes in the control voltage applied to its gate.

To linearize the voltage-current characteristic feeback may be employed to make the slope of this curve constant as a function of $V_{ds}$. However, if this feedback voltage is directly applied to the JFET along with the AGC control voltage the possibility exists of introducing an offset voltage into the output of the particular AGC stage.

Summary of the Invention

It is a general object of the present invention to provide an improved method and apparatus for gain controlling signals.

This and other objects are attained, in accordance with one aspect of the invention, by a broadband automatic gain control circuit comprising at least one amplifier/attentuator stage, each stage including at least one junction field effect transistor (JFET) device having its drain connected to a source of input signals, its source connected to ground, and its gate connected between a voltage divider; a buffer circuit having an input connected to the source of signals and the drain of the JFET and having an output for producing output signals electrically isolated from the input signals and further connected to one side of the voltage divider; and a source of voltage control signals applied to the other side of the voltage divider, whereby the gate of the JFET is biased by a buffered feedback voltage derived from the input signals and voltage control signals to change the gain characteristics of the amplifier/attenuator stage.

Another aspect includes a method of controlling an automatic gain control (AGC) stage utilizing a junction field effect transistor (JFET) having its drain connected to a source of input signals and its source connected to ground to control the gain or attenuation of the stage, comprising the steps of applying the buffered input signal to the gate of said JFET through one side of a voltage divider; applying a voltage control signal to said gate of said JFET through the other side of said voltage divider.

## Brief Description of the Drawing Figures

These and other features and advantages of the present invention will be readily understood with reference to the following detailed description of the preferred embodiment, when taken in conjunction with the drawing figures wherein:

Fig. 1 is a schematic diagram illustrating the principle components of the present invention;

Fig. 2 is a schematic diagram of one form of voltage shaping circuitry useful with the AGC circuit shown in Fig. 1;

Fig. 3 is a graph illustrating the characteristic curves of a JFET operated without feedback; and

Fig. 4 is a graph illustrating the characteristic curves of a JFET operated in accordance with the present invention.

## Detailed Description of the Preferred Embodiment

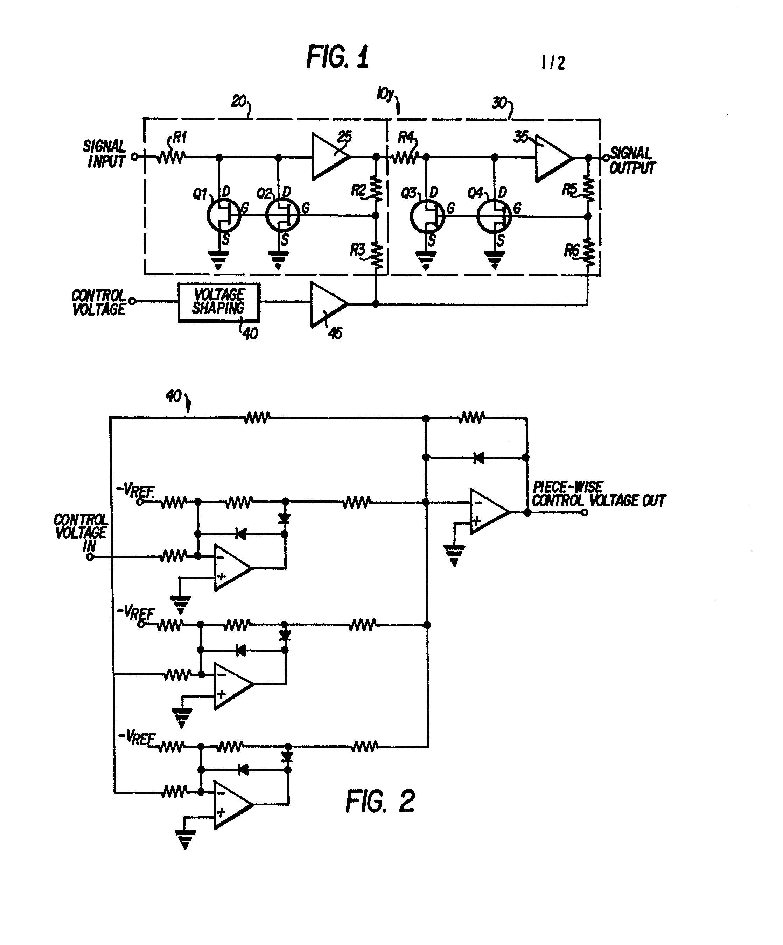

With reference to Fig. 1, an AGC circuit 10 is shown comprising first and second amplifier/attenuator stages 20 and 30, respectively. Each stage 20 and 30 is identical in construction and operation.

In stage 20 JFET devices Q1 and Q2 are connected in parallel with each other with respective drains, sources, and gates connected together. The sources of Q1 and Q2 are connected to ground while the drains are connected between an input resistor R1 and the input of a buffer circuit 25. Resistor R1 is connected to a source of input signals having a parameter which varies over time (such as amplitude, frequency, or phase). The output of buffer 25 is applied to a next stage 30 and to a voltage divider comprised of resistors R2 and R3. Resistors R2 and R3 preferably are of equal value for reasons explained more fully below. The gates of Q1 and Q2 are connected to a point between R2 and R3. This arrangement causes a buffered feedback voltage to be applied to the gates of Q1 and Q2 to thereby cause the voltage-current characteristic of Q1 and Q2 to be more nearly linear, as described below in more detail.

A control voltage, derived from the input signal, is applied to the gates of the JFETs via a buffer 45 and through divider resistor R3. Where desired, the control voltage can be applied to a voltage shaping circuit 40 prior to application to buffer 45.

One form of known voltage shaping circuit 40 is shown by way of example in Fig. 2 and comprises a series of operational amplifiers whose outputs are proportional to the control voltage upon the application of an input signal (the control voltage) when this input signal is above a threshold set by a reference voltage. — The reference voltage and proportions can be set such that the output of circuit 40 is in piece-wise increments which vary linearly, logarithmicaly, exponentially, etc., with the input signal. In this fashion, the AGC control voltage applied to the gates of the JFETs can be tailored to a particular received signal.

As mentioned above, amplifier/attenuator stage 30 is identical in operation and construction to that of stage 20 and comprises an input resistor R4 connected to the output of stage 20, and a pair of JFET devices having sources, drains, and gates tied together in parallel. The sources of Q3 and Q4 are connected to ground and their drains are connected to the input of a buffer 35 and R4. The gates of Q3 and Q4 are tied to a point between a voltage divider comprised of resistors R5 and R6. Resistors R5 and R6 are of substantially equal value, with the side of R5 remote from the gates of Q3 and Q4 being tied to the output of buffer 35 and the side of R6 remote from the gates of Q3 and Q4 being tied to the control voltage being applied from buffer 45. The output buffer 35 of stage 30 may be applied to yet another AGC amplifier/attenuator stage or to receiver circuitry (not shown) in a well-known fashion.

The theory of operation of each AGC amplifier/attenuator stage is as follows. When operated as a controlled gain amplifier, the current between drain and source in a JFET will behave according to the following equation:

$$(1) \quad i_{DS} = K[(V_{GS} - V_P)V_{DS} - (V_{DS})^2/2]$$

$$\text{for} \quad V_{DS} \leq V_{GS} - V_P \quad \text{and} \quad V_{GS} - V_P \geq 0 \qquad \text{(Region I)}$$

Where $i_{DS}$ is the drain-to-source current of the JFET, $V_{DS}$ is the voltage potential applied between the drain and source of the JFET, $V_{GS}$ is the gate-to-source bias potential, and $V_P$ (pinch-off voltage) and K are device constants whose values depend on the particular JFET being used.

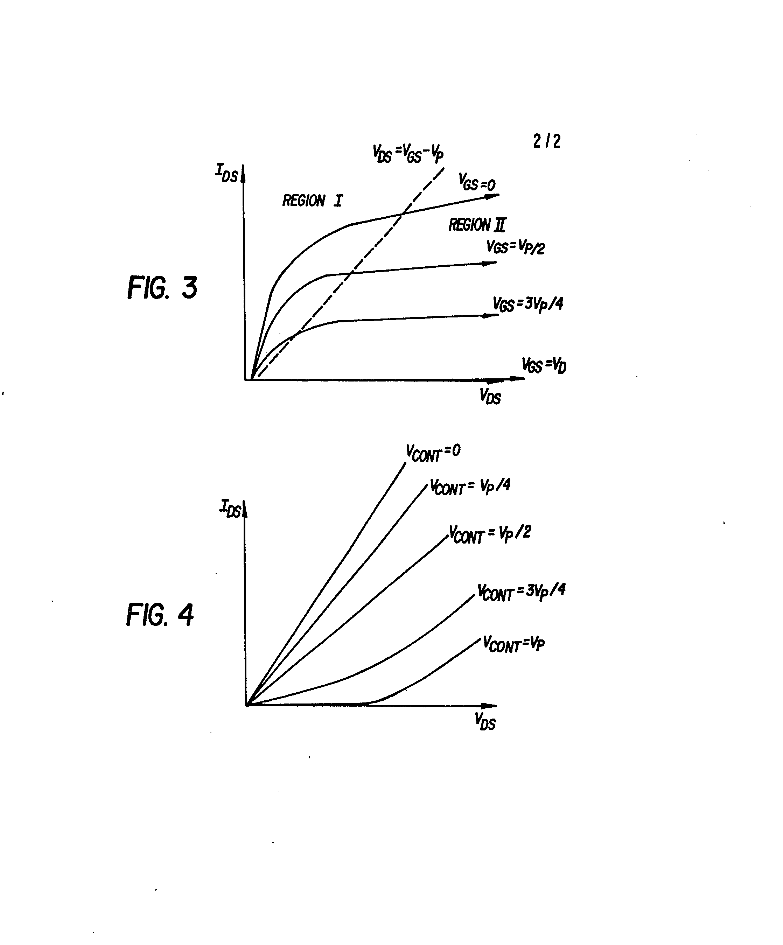

When plotted as a series of curves as shown in Fig. 3, it can be seen that the drain-to-source current, $i_{DS}$, will vary in proportion to the gate-to-source potential, $V_{GS}$. The slope of each of these curves is different and corresponds to the JFET drain-to-source channel resistance at any particular point. See Stephen D. Senturia and Bruce D. Wedlock, *Electronic Circuits and Applications*, John Wiley and Sons, New York, N.Y. 1975, pages 248-251 for a further discussion on the characteristics of FET devices.

In order to improve the operating characteristics of a JFET as an amplifier, part of the drain-to-source signal should be fed back to the gate to make the slope of each curve more nearly constant as a function of the drain-to-source potential, $V_{DS}$. Thus:

$$(2) \quad G_{DS} = 1/r_{DS} = i_{DS}/V_{DS} = K[V_{GS} - V_P - V_{DS}/2]$$

where $r_{DS}$ is the drain-to-source channel resistance of the JFET, and $G_{DS}$ is the channel conductance.

This implies that for a given value of gate-to-source voltage (e.g. AGC control voltage) an amount of feedback voltage $V_{DS}/2$ be fed back to the gate. The equation then becomes:

$$(3) \quad i_{DS}/V_{DS} = K[V_{GS} - V_P] = \text{constant} \qquad \text{(For Region I)}$$

This amount of feedback is provided by taking part of the signal being output by a buffer, such as 25 in Fig. 1, and feeding it through a voltage divider network, such as R2 and R3, where these two resistances are substantially equal in value. Since the gates of Q1 and Q2 are tied to the midpoint between R2 and R3 this will provide the required amount of feedback to the JFETs in order to more nearly linearize their characteristic. This improved linearization is shown in Fig. 4.

It will be appreciated that in order for the proper amount of feedback to be developed at the gates of the JFETs that the control voltage $V_{AGC}$ be a low impedance voltage source. This is why a buffer 45 is placed between the source of control voltage and the input to the voltage divider network of each amplifier/attenuator stage. Buffers 25 and 35 at the outputs of each stage 20 and 30, respectively, serve to provide a low impedance for the next stage and eliminate introduction of offset voltage into the JFET feedback loop as the AGC control voltage is varied and enable control voltages down to DC to be used. Thus, the described AGC circuit will be extremely broadband and capable of automatically controlling the gain of signals ranging from DC to an upper frequency limited only by the capacitance at the JFET-buffer junction and the frequency response of the buffer itself. One exemplary type of buffer is manufactured by National Semiconductor as its part no. LH003C. The use of more than one JFET in each stage will increase the dynamic range that the AGC circuit is capable of handling and the linearization of the JFET gain characteristic ensures low distortion over a wider operating range than heretofore possible.

While the present invention has been described in considerable detail certain obvious modifications would occur to those skilled in the art. For example, operational amplifiers could replace the buffers 25, 35 and 45. Although shown as paired together, a single JFET of sufficient dynamic range could be used in each stage. Alternatively, more than two JFETs could be paralleled together in each stage as desired.

The foregoing is not intended to be limitative but rather illustrative of the invention which is defined by the appended claims.

Claims

1.  A broadband automatic gain control circuit characterized by at least one amplifier/attentuator stage, each stage including:

at least one junction field effect transistor (JFET) device having its drain connected to a source of input signals, its source connected to ground, and its gate connected between a voltage divider;

a buffer circuit having an input connected to the source of signals and the drain of the JFET and having an output for producing output signals electrically isolated from the input signals and further connected to one side of the voltage divider; and

a source of voltage control signals applied to the other side of the voltage divider,

whereby the gate of the JFET is biased by a buffered feedback voltage derived from the input signals and voltage control signals to change the gain characteristics of the amplifier/attenuator stage.

2.  The automatic gain control circuit of claim 1 characterized in that the voltage divider comprises a pair of resistances of substantially equal value, such that approximately one-half the voltage applied between the drain and source of each JFET is applied between the drain and gate of each JFET.

3.  The automatic gain, control circuit of claim 1 or 2 characterized in that there are at least two JFET devices connected in parallel to each other to thereby increase the dynamic range of the amplifier/attenuator stage.

4.  The automatic gain control circuit of claim 1, 2 or 3 characterized in that the input signals have a parameter which varies over time and the control signal is a voltage which is proportional to the average strength of the input signal.

5.  The automatic gain control circuit of claim 1, 2, 3 or 4 characterized in that the control voltage is applied to a voltage shaping circuit whose output varies in proportion to certain discrete preselected levels of the control voltage.

6. A method of controlling an automatic gain control (AGC) stage utilizing a junction field effect transistor (JFET) having its drain connected to a source of input signals and its source connected to ground to control the gain or attenuation of the stage, characterized by the steps of:

applying the buffered input signal to the gate of said JFET through one side of a voltage divider;

applying a voltage control signal to said gate of said JFET through the other side of said voltage divider.

## FIG. 1

FIG. 1

SIGNAL INPUT

SIGNAL OUTPUT

CONTROL VOLTAGE

VOLTAGE SHAPING

## FIG. 2

CONTROL VOLTAGE IN

PIECE-WISE CONTROL VOLTAGE OUT

FIG. 2

FIG. 3

FIG. 4